# FASCICULE DE BREVET EUROPEEN

(11) **EP 2 208 276 B1**
(45) Date de publication et mention de la délivrance du brevet: **01.02.2012**
(21) Numéro de dépôt: 08847855.7
(22) Date de dépôt: 21.10.2008
(51) Int. Cl.: H02J 7/00, H02J 7/35, H02J 3/38, H02M 7/483

(54) **PROCÉDÉ DE FONCTIONNEMENT ET DISPOSITIF DE COMMANDE D'UNE INSTALLATION ÉNERGÉTIQUE À MODULES PHOTOVOLTAÏQUES**
BETRIEBSVERFAHREN UND VORRICHTUNG ZUR STEUERUNG EINER STROMANLAGE MIT PHOTOVOLTAIKMODULEN
METHOD OF OPERATION AND DEVICE FOR CONTROLLING AN ENERGY INSTALLATION WITH PHOTOVOLTAIC MODULES

(30) Priorité: 08.11.2007 FR 0758882
(43) Date de publication de la demande: 21.07.2010
(73) Titulaire: Hauf, Harald, 83500 La Seyne Sur Mer (FR); Van, Sothachett, 38420 Le Versoud (FR)
(72) Inventeur: Hauf, Harald, 83500 La Seyne Sur Mer (FR); Van, Sothachett, 38420 Le Versoud (FR)
(74) Mandataire: Marchand, André
(86) Numéro de dépôt international: PCT/IB2008/002829
(87) Numéro de publication internationale: WO 2009/060273

(56) Documents cités:
- US-A- 6 060 790
- US-A1- 2007 034 246
- US-A1- 2007 107 767
- US-B1- 6 583 522

## Description

La présente invention concerne le domaine des installations énergétiques comprenant des modules photovoltaïques.

Il est courant de réaliser des installations énergétiques qui comprennent des modules photovoltaïques en général constitués de panneaux de cellules photovoltaïques reliés, de façon figée, soit en parallèle soit en série à un onduleur qui transforme le courant continu qu'il reçoit en un courant alternatif. Le choix préétabli du mode de liaison dépend des caractéristiques électriques des modules photovoltaïques choisis, en général la puissance maximum qu'ils peuvent délivrer en fonction de l'ensoleillement du lieu recevant ces 15 modules, et dépend des caractéristiques électriques de l'onduleur choisi, en général la puissance électrique d'entrée pour laquelle sa puissance électrique de sortie est maximum.

La présente invention a pour but d'améliorer le rendement des installations énergétiques à modules photovoltaïques, en tenant compte non seulement des caractéristiques électriques individuelles de ces derniers mais ainsi des conditions d'ensoleillement et d'environnement variables des lieux déterminés où elles sont placées.

Le document US 6,060,790 décrit un dispositif de commutation d'une matrice de modules photovoltaïques comprenant des chaînes de modules photovoltaïques en série. Le dispositif est configuré pour commuter la matrice entre une première configuration dans laquelle une première chaîne de modules est agencée en parallèle avec d'autres chaînes de modules, et une seconde configuration dans laquelle la première chaîne de modules est agencée en série avec les autres chaînes de modules.

Le document US 2007/0034246 décrit un dispositif générateur de tension comprenant une pluralité de modules solaires générateurs de tension. Le dispositif comprend une pluralité d'interrupteurs pour connecter ou déconnecter des bornes positives des modules solaires à un bus positif et connecter ou déconnecter des bornes négatives des modules solaires à un bus négatif, afin de contrôler l'intensité d'un courant continu fourni par le dispositif.

La présente invention a pour objet un procédé de fonctionnement d'une installation énergétique comprenant au moins deux modules photovoltaïques et un onduleur.

Ce procédé comprend, respectivement à des instants prédéterminés, les étapes suivantes :
mesurer les valeurs du courant et/ou de la tension délivrés par chaque module photovoltaïque;
calculer et/ou choisir une première grandeur électrique en fonction des valeurs mesurées dans le cas où lesdits modules photovoltaïques seraient connectés en un mode parallèle et une seconde grandeur électrique en fonction des valeurs mesurées dans le cas où lesdits modules photovoltaïques seraient connectés en un mode série ;
comparer lesdites première et seconde grandeurs électriques l'une par rapport à l'autre et/ou par rapport à une grandeur de référence ;
puis sélectionner et établir un mode de connexion des modules photovoltaïques à l'onduleur en fonction du résultat de la comparaison.

Selon l'invention, lesdites première et seconde grandeurs électriques peuvent être des première et seconde puissances électriques et le mode de connexion correspondant à la plus grande puissance calculée peut être choisi et établi.

Selon l'invention, les première et seconde grandeurs électriques peuvent être des valeurs de courants et le mode de connexion correspondant au plus grand courant calculé peut être choisi et établi.

La présente invention a également pour objet un procédé de fonctionnement d'une installation énergétique comprenant une multiplicité de modules photovoltaïques et au moins un onduleur.

Ce procédé comprend, respectivement à des instants prédéterminés, les étapes suivantes :
mesurer les valeurs du courant et/ou de la tension délivrés par chaque module photovoltaïque ;
calculer et/ou choisir des grandeurs électriques intermédiaires correspondant respectivement à une multiplicité de modes différents de connexion en mode série et/ou en mode parallèle desdits modules photovoltaïques ;
comparer les grandeurs électriques intermédiaires les unes par rapport aux autres et/ou par rapport à une grandeur de référence ;
puis sélectionner et établir un mode de connexion des modules photovoltaïques à l'onduleur en fonction du résultat de la comparaison.

Selon l'invention, lesdites grandeurs électriques intermédiaires peuvent être des puissances électriques et le mode de connexion correspondant à la plus grande puissance calculée peut être choisi et établi.

La présente invention a également pour objet un procédé de fonctionnement d'une installation énergétique comprenant au moins un module photovoltaïque et au moins deux onduleurs caractérisés par des grandeurs de fonctionnement et/ou des plages de grandeurs de fonctionnement différentes.

Ce procédé comprend, respectivement à des instants prédéterminés, les étapes suivantes :
mesurer les valeurs du courant et/ou de la tension délivrés par le module photovoltaïque ;
calculer et/ou choisir une grandeur électrique intermédiaire en fonction des valeurs mesurées ;
comparer cette grandeur électrique intermédiaire à au moins une grandeur de référence et/ou au moins une plage de grandeur de référence caractérisant électriquement chacun desdits onduleurs ;
puis relier ledit module soit à l'un desdits onduleurs soit à l'autre en fonction du résultat de ladite comparaison.

La présente invention a également pour objet un procédé de fonctionnement d'une installation énergétique comprenant une multiplicité de modules photovoltaïques et une multiplicité d'onduleurs caractérisés par des grandeurs de fonctionnement et/ou des plages de grandeurs de fonctionnement différentes.

Ce procédé comprend, respectivement à des instants prédéterminés, les étapes suivantes :
mesurer les valeurs du courant et/ou de la tension délivrés par chaque module photovoltaïque ;
calculer et/ou choisir des grandeurs électriques intermédiaires en fonction d'une multiplicité de modes différents de connexion en mode série et/ou en mode parallèle des modules photovoltaïques aux onduleurs ;
comparer les grandeurs électriques intermédiaires les unes par rapport aux autres et/ou par rapport à des grandeurs de référence et/ou des plages de grandeurs de référence caractérisant électriquement les onduleurs ;
et sélectionner et établir un mode de connexion des modules photovoltaïques auxdits onduleurs pour lequel la grandeur électrique intermédiaire correspond approximativement à une grandeur électrique de référence et/ou une plage de grandeurs électriques de référence caractérisant électriquement au moins l'un des onduleurs.

Selon l'invention, les grandeurs électriques peuvent être des puissances électriques ou des courants.

La présente invention a également pour objet un procédé de fonctionnement d'une installation énergétique comprenant une multiplicité de modules photovoltaïques et une multiplicité d'onduleurs caractérisés par des grandeurs de fonctionnement et/ou des plages de grandeurs de fonctionnement différentes, procédé comprenant, respectivement à des instants prédéterminés, les étapes suivantes :
mesurer les valeurs du courant et/ou de la tension délivrés par chaque module photovoltaïque ;
calculer des grandeurs électriques de sortie des onduleurs en fonction d'une multiplicité de modes différents de connexion en mode série et/ou en mode parallèle des modules photovoltaïques aux onduleurs et en fonction de grandeurs électriques de fonctionnement et/ou de plages de grandeurs électriques de fonctionnement caractérisant électriquement les onduleurs,
comparer les grandeurs électriques de sortie calculées
sélectionner et établir un mode de connexion des modules photovoltaïques auxdits onduleurs pour lequel la grandeur électrique de sortie calculée d'au moins l'un des onduleurs correspond approximativement à une grandeur de référence et/ou une plage de grandeurs de référence caractérisant électriquement cet onduleur.

Selon l'invention, les grandeurs électriques peuvent être des puissances électriques et les grandeurs de fonctionnement et/ou de plages de grandeurs de fonctionnement peuvent être des courbes de puissance.

La présente invention a également pour objet un dispositif de commande d'une installation énergétique comprenant une multiplicité de modules photovoltaïques et au moins un onduleur.

Ce dispositif comprend : des moyens de commutation pour sélectivement relier lesdits modules photovoltaïques audit onduleur en les connectant sélectivement en mode parallèle et/ou en mode série ; des moyens pour mesurer la valeur du courant et/ou de la tension délivrés par lesdits modules photovoltaïques ; et des moyens de gestion et de commande des moyens de commutation en fonction des valeurs mesurées.

La présente invention a également pour objet un dispositif de commande d'une installation énergétique comprenant une multiplicité de modules photovoltaïques et une multiplicité d'onduleurs,

Ce dispositif comprend : des premiers moyens de commutation pour sélectivement placer lesdits modules photovoltaïques en mode parallèle et/ou en mode série vers sélectivement des paires de bornes intermédiaires, des seconds moyens de commutation pour sélectivement relier lesdites paires de bornes intermédiaires aux onduleurs en mode parallèle et/ou en mode série, des moyens pour mesurer la valeur du courant et/ou de la tension délivrés par chaque module photovoltaïque, et des moyens de gestion et de commande des premiers et seconds moyens de commutation en fonction des valeurs mesurées et/ou en fonction de grandeurs électriques ou de plages de grandeurs électriques caractérisant lesdits onduleurs.

La présente invention sera mieux comprise à l'étude de différentes installations énergétiques et de leurs modes de fonctionnement, décrits à titre d'exemples non limitatifs et illustrés par le dessin annexé sur lequel :
- la figure 1 représente schématiquement une installation énergétique selon l'invention ;
- la figure 2 représente schématiquement un mode de fonctionnement de l'installation énergétique de la figure 1 ;
- la figure 3 représente schématiquement un autre mode de fonctionnement de l'installation énergétique de la figure 1 ;
- la figure 4 représente schématiquement une autre installation énergétique selon l'invention ;
- la figure 5 représente schématiquement un mode de fonctionnement de l'installation énergétique de la figure 4 ;
- la figure 6 représente schématiquement une autre installation énergétique selon l'invention ;
- la figure 7 représente schématiquement une autre installation énergétique selon l'invention ;
- la figure 8 représente schématiquement un mode de fonctionnement de l'installation énergétique de la figure 7 ;
- la figure 9 représente schématiquement un autre mode de fonctionnement de l'installation énergétique de la figure 7 ;
- la figure 10 représente schématiquement une autre installation énergétique selon l'invention ;
- et la figure 11 représente schématiquement une autre installation énergétique selon l'invention, basée sur celle de la figure 10.

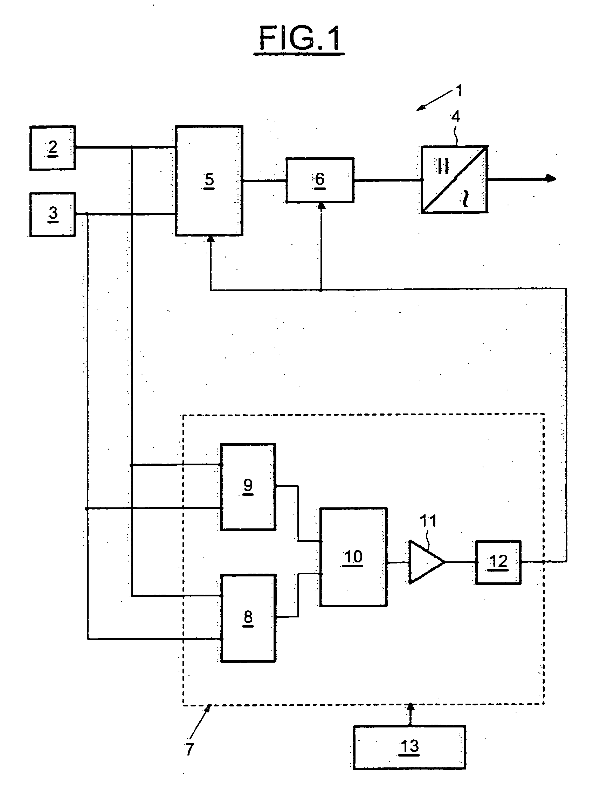

En se reportant aux figures 1 à 3, on peut voir qu'on a représenté une installation énergétique 1 qui comprend deux modules photovoltaïques 2 et 3 et un onduleur 4, ainsi qu'un premier groupe de commutateurs électriques 5 et un second groupe de commutateurs électriques 6 montés entre les modules photovoltaïques 2 et 3 et l'onduleur 4.

Le groupe de commutateurs électriques 5 et le second groupe de commutateurs électriques 6, sont agencés de façon que les pôles des modules photovoltaïques 2 et 3 puissent être reliés ou connectés aux pôles (+) et (-) de l'onduleur 4 soit en mode parallèle Mp soit en mode série Ms.

L'installation énergétique 1 comprend en outre un circuit électronique 7 de gestion et de commande des commutateurs électriques de chacun des groupes 5 et 6 de commutateurs électriques.

Le circuit électronique 7 comprend un organe 8 de mesure du courant délivré par chacun des modules photovoltaïques 2 et 3, un organe associé 8a de mémorisation temporaire des valeurs des courants mesurées, un organe 9 de mesure de la tension délivrée par chacun des modules photovoltaïques 2 et 3 et un organe associé 9a de mémorisation temporaire des valeurs des tensions mesurées.

Le circuit électronique 7 comprend en outre un organe de calcul 10 adapté pour calculer, en appliquant les formules de calcul connues de l'homme du métier, la puissance électrique Pp susceptible d'être délivrée à l'onduleur 4 dans le cas où les modules photovoltaïques 2 et 3 sont connectés en mode parallèle Mp et la puissance électrique Ps susceptible d'être délivrée à l'onduleur 4 dans le cas où les modules photovoltaïques 2 et 3 sont connectés en mode série Ms.

Le circuit électronique 7 comprend en outre un organe de comparaison 11 adapté pour comparer les puissances électriques calculées Pp et Ps.

Le circuit électronique 7 comprend en outre un organe 12 de sélection et de commande qui est adapté ou programmé pour sélectionner le mode de connexion correspondant à la puissance électrique la plus grande et pour commander les commutateurs électriques de chacun des groupes 5 et 6 de commutateurs électriques pour connecter les modules photovoltaïques 2 et 3 à l'onduleur 4 conformément au mode de connexion choisi ou sélectionné.

Le circuit électronique 7 est soumis à une horloge 13 adaptée pour délivrer un signal d'horloge Sh au circuit électronique 7, à des instants prédéterminés, afin de déclencher, à chaque signal d'horloge, un cycle de sélection de mode connexion. Les écarts de temps séparant deux signaux d'horloge peuvent être constants ou variables. Par exemple, un signal d'horloge Sh peut être délivré tous les quarts d'heure.

Ainsi, à chaque signal d'horloge, un ordre de mesure est envoyé aux organes de mesure 8 et 9, un ordre de calcul est envoyé à l'organe de calcul 10, un ordre de comparaison est envoyé à l'organe de comparaison 11 et un ordre de sélection et de commande est envoyé à l'organe 12 de sélection et de commande.

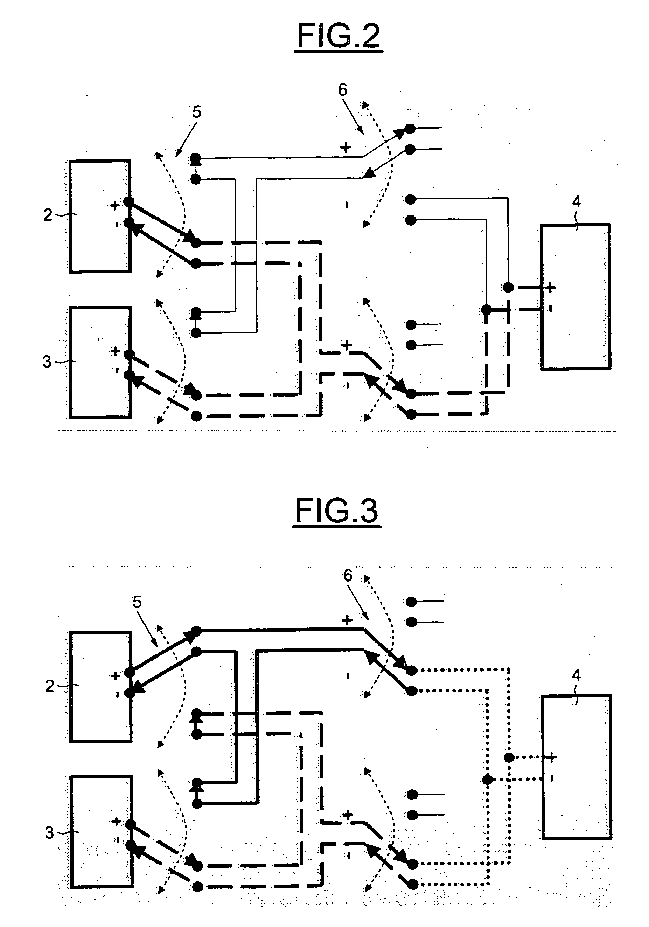

Si la puissance Ps calculée est plus grande que la puissance Pp calculée, l'organe 11 de sélection et de commande sélectionne le mode parallèle Ms et commande les commutateurs électriques de chacun des groupes 5 et 6 de commutateurs électriques pour que les modules photovoltaïques 2 et 3 soient reliés à l'onduleur 4 en mode série Ms. Ce mode de connexion est représenté sur la figure 2.

Si la puissance électrique Pp calculée est plus grande que la puissance électrique Ps calculée, l'organe 11 de sélection et de commande sélectionne le mode parallèle Mp et commande les commutateurs électriques de chacun des groupes 5 et 6 de commutateurs électriques pour que les modules photovoltaïques 2 et 3 soient reliés à l'onduleur 4 en mode parallèle Mp. Ce mode de connexion est représenté sur la figure 3.

Le mode de connexion établi est maintenu jusqu'au cycle de sélection de mode connexion suivant. A chaque cycle de sélection de mode connexion, le mode de connexion précédemment établi est maintenu ou changé en fonction du résultat de la comparaison des puissances électriques Pp et Ps calculées.

Dans une variante simplifiée, on pourrait ne considérer que les signaux issus des capteurs 8 de mesure de courant, en estimant que les tensions aux bornes des modules sont quasiment similaires.

Bien entendu, le nombre de modules photovoltaïques n'est pas limité à deux. Ce qui vient d'être décrit peut s'appliquer à un nombre quelconque de modules photovoltaïques.

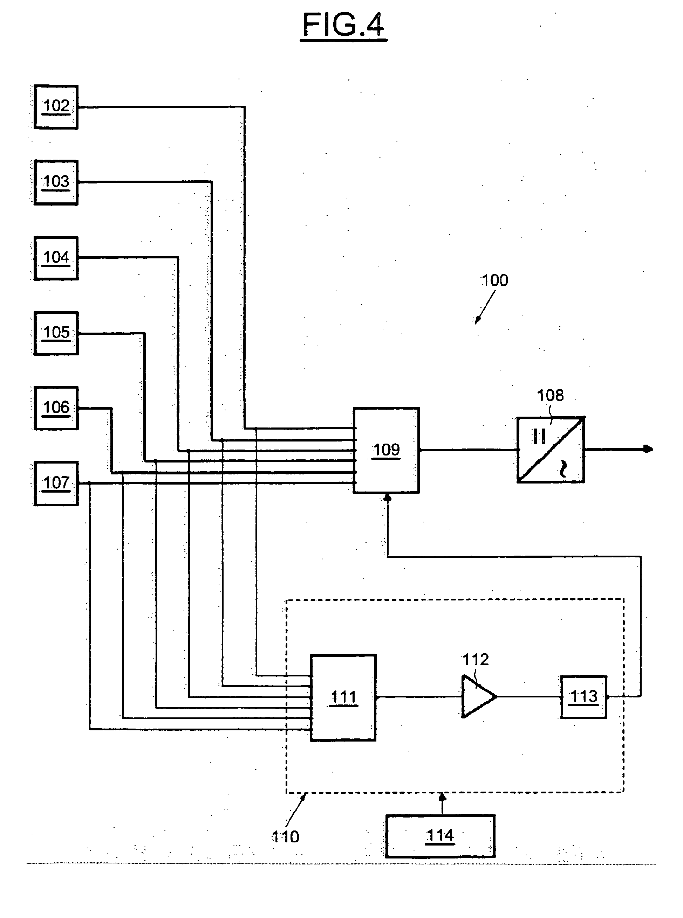

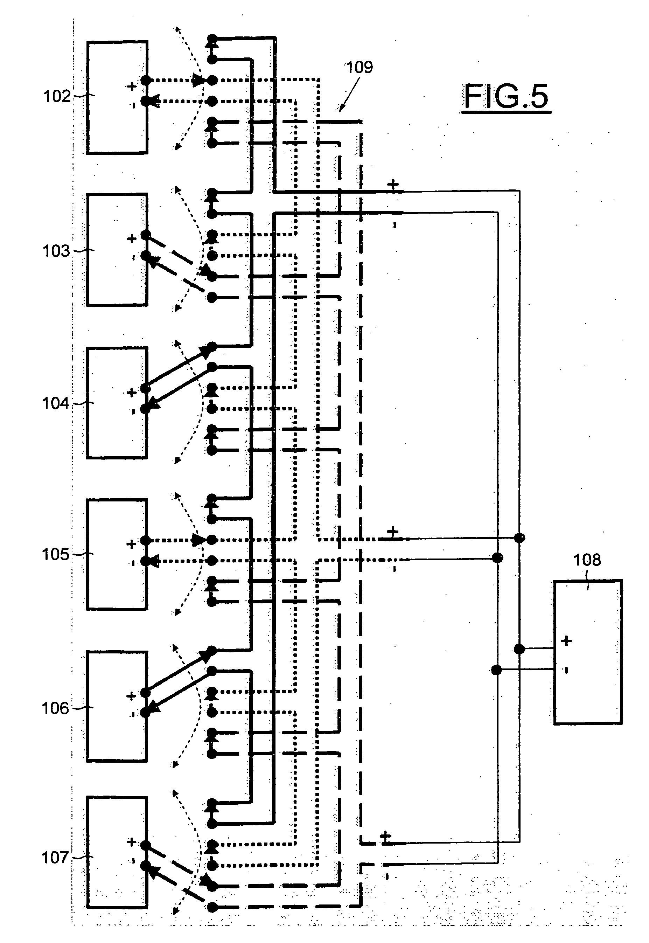

En se reportant aux figures 4 et 5, on peut voir qu'on a représenté une installation énergétique 100 qui comprend six modules photovoltaïques 102, 103, 104, 105, 106 et 107 et un onduleur 108, ainsi qu'un groupe de commutateurs électriques 109 montés entre les modules photovoltaïques 102 à 107 et l'onduleur 108.

Le groupe de commutateurs électriques 109 est agencé de façon à permettre d'établir, parmi les quinze combinaisons possibles, trois modes de connexion en série Ms entre les pôles de sortie des modules photovoltaïques 102 à 107 et les pôles d'entrée de l'onduleur 108, chaque mode de connexion en série Ms comprenant deux quelconques de ces modules photovoltaïques 102 à 107 mis en série, qui sont en conséquence, par paires en série, connectés en mode parallèle Mp sur les pôles d'entrée de l'onduleur 108.

L'installation énergétique 100 comprend en outre un circuit électronique 110 de gestion et de commande des commutateurs électriques du groupe 109 de commutateurs électriques.

Le circuit électronique 110 comprend un organe 111 de mesure du courant délivré par chacun des modules photovoltaïques 102 à 107.

Le circuit électronique 110 comprend en outre un organe de comparaison 112, adapté ou programmé pour classer en ordre croissant, respectivement décroissant, les valeurs mesurées des courants.

Le circuit électronique 110 comprend en outre un organe de sélection et de commande 113, adapté ou programmé pour commander les commutateurs du groupe de commutateurs électriques 109 de façon à connecter sur les pôles d'entrée de l'onduleur 108, (a) en mode série Ms les deux modules photovoltaïques délivrant les courants les plus élevés, (b) en mode série Ms les deux modules photovoltaïques délivrant les courants intermédiaires et (c) en mode série Ms les deux modules photovoltaïques délivrant les courants les plus faibles.

Comme dans l'exemple précédent, le circuit électronique 110 est soumis à une horloge 114 adaptée pour délivrer un signal d'horloge Sh à des instants prédéterminés, afin de déclencher, à chaque signal d'horloge, un cycle de sélection de mode connexion.

Ainsi, à chaque signal d'horloge, un ordre de mesure est envoyé à l'organe de mesure de valeurs de courants 111, un ordre de comparaison est envoyé à l'organe de comparaison 112, et un ordre de sélection et de commande est envoyé à l'organe 113 de sélection et de commande.

Par exemple, telles qu'indiquées sur la figure 4, l'organe de mesure 111 mesure les valeurs suivantes :
- pour le module photovoltaïque 102 : 8,0 Ampères,
- pour le module photovoltaïque 103 : 9,8 Ampères,
- pour le module photovoltaïque 104 : 8,9 Ampères,
- pour le module photovoltaïque 105 : 10,2 Ampères,
- pour le module photovoltaïque 106 : 8,2 Ampères,
- et pour le module photovoltaïque 107 : 9,3 Ampères.

Après comparaison par l'organe de comparaison 112 de ces valeurs de courants mesurées, l'organe de sélection et de commande 113 commande les commutateurs du groupe de commutateurs électriques 109 de façon que soient établies les connexions suivantes :
- les modules photovoltaïques 102 et 106 sont connectés en mode série Ms sur les pôles d'entrée de l'onduleur 108,
- les modules photovoltaïques 103 et 105 sont connectés en mode série Ms sur les pôles d'entrée de l'onduleur 108,
- et les modules photovoltaïques 104 et 107 sont connectés en mode série Ms sur les pôles d'entrée de l'onduleur 108.

Il s'ensuit que les paires ci-dessus de modules photovoltaïques, connectés en série, sont connectées en mode parallèle Mp sur les pôles d'entrée de l'onduleur 108.

Les connexions correspondantes sont représentées sur la figure 5.

Le mode de connexion établi ci-dessus est maintenu jusqu'au cycle de sélection de mode de connexion suivant. A chaque cycle de sélection de mode de connexion, le mode de connexion précédemment établi est maintenu ou changé en fonction du résultat de la comparaison des valeurs mesurées des courants délivrés par chaque module photovoltaïque 102 à 107.

Par exemple, au cycle suivant, l'organe de mesure 111 mesure les valeurs suivantes :
- pour le module photovoltaïque 102 : 8,0 Ampères,
- pour le module photovoltaïque 103 : 10,1 Ampères,
- pour le module photovoltaïque 104 : 11 Ampères,
- pour le module photovoltaïque 105 : 10,2 Ampères,
- pour le module photovoltaïque 106 : 8,2 Ampères,
- et pour le module photovoltaïque 107 : 9,3 Ampères.

Alors, l'organe de sélection et de commande 113 commande les commutateurs du groupe de commutateurs électriques 109 de façon que soient établies les connexions suivantes :
- les modules photovoltaïques 104 et 105 sont connectés en mode série Ms sur les pôles d'entrée de l'onduleur 108,
- les modules photovoltaïques 103 et 107 sont connectés en mode série Ms sur les pôles d'entrée de l'onduleur 108,
et les modules photovoltaïques 102 et 106 sont connectés en mode série Ms sur les pôles d'entrée de l'onduleur 108.

Bien entendu, ce qui vient d'être décrit n'est pas limité à six modules photovoltaïques, associables par paires, mais peut s'étendre à un nombre quelconque de modules photovoltaïques, qui pourraient être associés en des groupes en série adaptés.

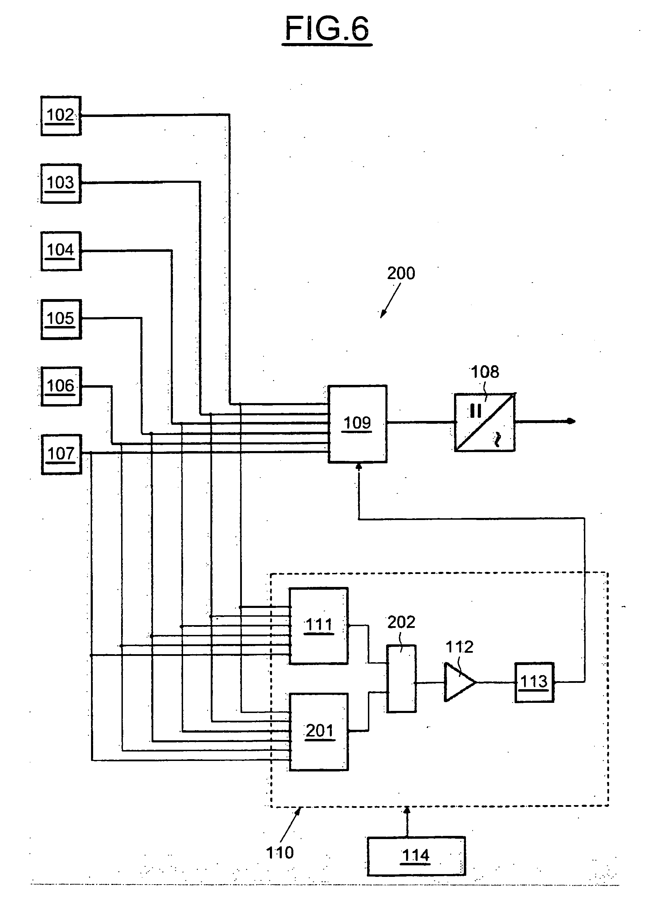

En se reportant à la figure 6, on a représenté une installation énergétique 200 qui comprend, structurellement, l'installation énergétique 100 des figures 4 et 5 et qui comprend en outre un organe 201 de mesure des tensions délivrées par chaque module photovoltaïque 102 à 107 et un organe 202 de calcul des puissances électriques susceptibles d'être délivrées par chaque module photovoltaïque 102 à 107, à partir des mesures faites par les organes 111 et 201, en utilisant les formules de calcul connues de l'homme du métier.

Dans ce cas, à chaque signal d'horloge Sh délivré par l'horloge 114, l'organe de calcul 202 calcule les puissances électriques susceptibles d'être délivrées par chaque module photovoltaïque 102 à 107 à partir des valeurs correspondantes de courants et de tensions délivrés par les organes 111 et 201 et l'organe de comparaison 112 est adapté ou programmé pour comparer et classer par ordre croissant, respectivement décroissant, les puissances électriques calculées.

Pour établir le nouveau mode de connexion, l'organe de sélection et de commande 113 est adapté ou programmé pour commander les commutateurs du groupe de commutateurs électriques 109 de façon à connecter, sur les pôles d'entrée de l'onduleur 108, (a) en mode série Ms les deux modules photovoltaïques délivrant les puissances électriques dont les valeurs sont les plus élevées, (b) en mode série Ms les deux modules photovoltaïques délivrant les puissances électriques dont les valeurs sont intermédiaires, et (c) en mode série Ms les deux modules photovoltaïques délivrant les puissances électriques dont les valeurs sont les plus faibles. Comme dans l'exemple précédent, il existe quinze combinaisons possibles.

Dans une variante simplifiée, on pourrait ne considérer que les signaux issus des capteurs 111 de mesure de courant, en estimant que les tensions aux bornes des modules sont quasiment similaires.

Selon une variante de réalisation de l'installation de la figure 6, à chaque signal d'horloge Sh délivré par l'horloge 114, l'organe de calcul 202 est adapté ou programmé pour calculer, en utilisant les formules de calcul connues de l'homme du métier, la puissance électrique totale susceptible d'être délivrée à l'onduleur 108 dans chacune des quinze combinaisons possibles par paires des modules photovoltaïques 102 à 107. L'organe de comparaison 112 est adapté ou programmé pour comparer les puissances totales calculées.

L'organe de sélection et de commande 113 est adapté ou programmé pour commander les commutateurs du groupe de commutateurs électriques 109 de façon à connecter, sur les pôles d'entrée de l'onduleur 108, les modules photovoltaïques 102 à 107 pour établir le mode de connexion correspondant à la combinaison de connexions fournissant la puissance électrique totale la plus grande à l'onduleur 108.

Le choix d'une combinaison de connexions peut être soumis à une condition supplémentaire dépendant de la tension d'entrée susceptible d'être supportée par l'onduleur 108.

Pour cela, l'organe de calcul 202 est adapté pour calculer la tension Ud délivrée à l'entrée de l'onduleur 108 pour chaque combinaison de connexions et l'organe de sélection et de commande 113 est soumis à une valeur ou une plage Ur de référence ou de consigne caractérisant l'onduleur 108, par exemple une tension maximum et/ou une tension minimum et/ou une plage de tensions.

L'organe de comparaison 112 et l'organe de sélection et de commande 113 sont adaptés ou programmés de façon à éliminer la ou les combinaisons de connexions fournissant des puissances électriques totales qui sont associées à des tensions d'entrée qui ne respectent pas ladite valeur ou plage Ur. L'organe de sélection et de commande 113 sélectionne et établit la combinaison de connexions compatible et à meilleur rendement.

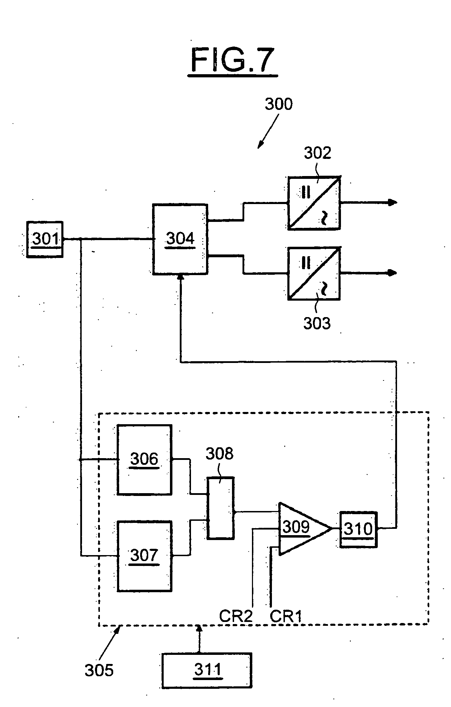

En se reportant aux figures 7 à 9, on peut voir qu'on a représenté une installation énergétique 300 qui comprend un module photovoltaïque 301 et deux onduleurs 302 et 303, un commutateur électrique 304 montés entre les pôles de sortie du module photovoltaïque 301 et les pôles d'entrée des onduleurs 302, et un circuit électronique 305 de gestion et de commande du commutateur 304 pour sélectivement relier le module photovoltaïque 301 soit à l'onduleur 302 soit à l'onduleur 303.

Les onduleurs 302 et 303 sont choisis de façon qu'ils présentent des caractéristiques ou des grandeurs de fonctionnement et/ou des plages de grandeurs de fonctionnement différentes. Couramment, les onduleurs sont caractérisés par une courbe de rendement reliant des puissances électriques d'entrée à des puissances électriques de sortie. Pour un bon usage d'un onduleur, il est souhaitable que la puissance électrique d'entrée soit à des valeurs situées dans la zone de rendement le plus élevé.

Le circuit électronique de gestion et de commande 305 comprend un organe 306 de mesure du courant et un organe 307 de mesure de la tension, qui sont délivrés par le module photovoltaïque 301, et un organe 308 de calcul de la puissance électrique qui est délivrée par le module photovoltaïque 301, en utilisant les formules de calcul connues de l'homme du métier.

Le circuit électronique de gestion et de commande 305 comprend en outre un organe de comparaison 309, adapté ou programmé pour comparer la puissance électrique calculée avec les valeurs de référence CR1 et CR2 situées dans la zone de rendement le plus élevé pour chaque onduleur 302 et 303, et un organe de sélection et de commande 310, adapté ou programmé pour commander le commutateur 304 de façon à commuter l'onduleur 301 vers l'onduleur adapté pour fournir le meilleur rendement.

Comme dans les exemples précédents, à chaque signal d'horloge Sh délivré par une horloge 311, les organes 306 et 307 mesurent le courant et la tension délivrés par le module photovoltaïque 301, l'organe 308 calcule la puissance électrique correspondante, l'organe 309 compare cette puissance calculée aux valeurs de référence CR1 et CR2 et l'organe 310 place le commutateur sur un mode de connexion correspondant de façon à commuter l'onduleur 301 vers l'onduleur adapté pour fournir le meilleur rendement, en maintenant le mode de connexion antérieur ou en changeant d'ondulateur.

Par exemple, l'onduleur 302 peut présenter une plage de rendement optimal contenant une valeur maximum égale à 1000 Watts et l'onduleur 303 peut présenter une plage de rendement optimal contenant une valeur maximum égale à 500 Watts, ces plages de rendement présentant une valeur commune de basculement de commutation par exemple égale à 650 Watts.

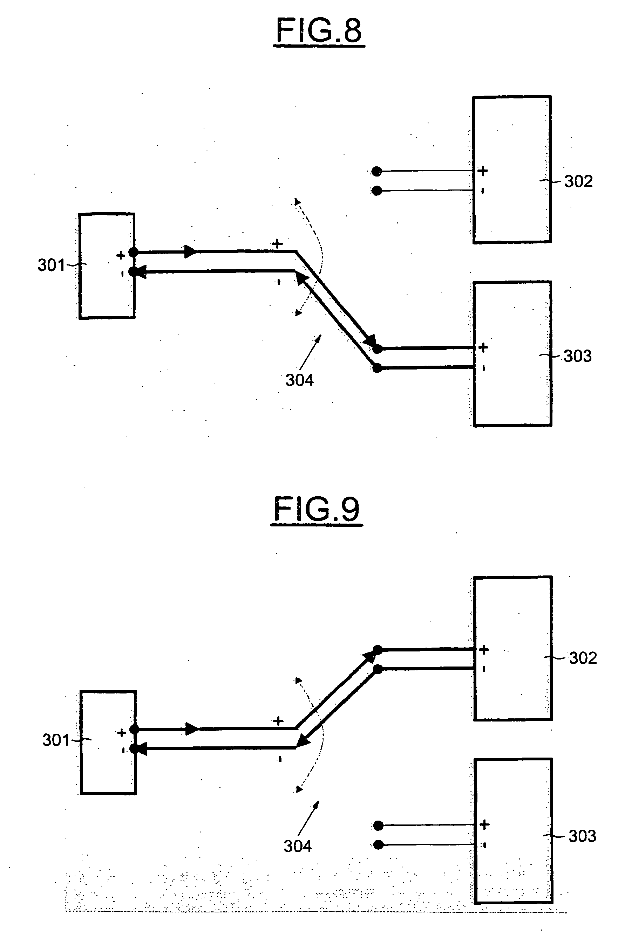

Si la valeur de la puissance électrique calculée, susceptible d'être délivrée par module photovoltaïque 301, est égale par exemple à 400 Watts, le circuit électronique de gestion et de commande 305 connectera le module photovoltaïque 301 à l'onduleur 303. C'est le cas représenté sur la figure 8.

Si la valeur de la puissance électrique calculée, susceptible d'être délivrée par module photovoltaïque 301, est égale par exemple à 800 Watts, le circuit électronique de gestion et de commande 305 connectera le module photovoltaïque 301 à l'onduleur 302. C'est le cas représenté sur la figure 9.

Selon une autre réalisation, le module photovoltaïque 301 pourrait comprendre en partie l'installation 1 décrite en référence aux figures 1 à 3 ou l'installation 100 décrite en référence aux figures 4 et 5 ou l'installation 200 décrite en référence à la figure 6.

En effet, à la place du module photovoltaïque 301, on pourrait prévoir de connecter dans le premier cas les bornes de sortie du commutateur 6 ou dans le second cas les bornes de sortie du commutateur 109, aux bornes d'entrée du commutateur 304 et aux organes de mesure 306 et 307.

Au signal d'horloge Sh, dans un premier temps, le circuit électronique 7 ou le circuit électronique 110 remplirait leurs fonctions décrites précédemment et, dans un second temps, ce serait le circuit électronique 305, en prenant pour origine les bornes de sortie du commutateur 6 ou les bornes de sortie du commutateur 109.

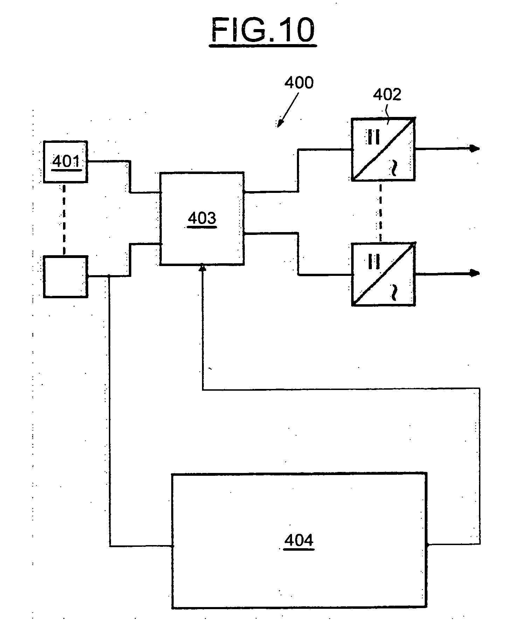

Maintenant, à partir des exemples qui viennent d'être décrits, il est proposé sur la figure 10 une installation énergétique 400 plus générale, qui comprend un nombre N de modules photovoltaïques 401, un nombre M d'onduleurs 402, un organe de commutation 403 pour sélectivement relier les modules photovoltaïque 401 aux onduleurs 402.

L'installation énergétique 400 comprend en outre un circuit électronique 404 de gestion et de commande de l'organe de commutation 403 en fonction de grandeurs mesurées ou calculées ou de référence ou de rendement ou de fonctionnement ou de consigne, issues des modules photovoltaïques 401 et éventuellement des onduleurs 402, pour établir, à des moments prédéterminés définis par une horloge et sélectivement, un mode particulier de connexion des modules photovoltaïque 401 aux onduleurs 402, conformément à un programme.

Par exemple, ce programme peut être adapté ou programmé pour rechercher puis établir un mode particulier ou une combinaison particulière de connexions, le mieux approprié pour que un ou certains ou les onduleurs délivrent une puissance électrique globale de sortie la plus élevée possible pendant chaque période, estimée en fonction des mesures des courants et/ou des tensions et/ ou des puissances calculées à chaque cycle de sélection et de commande.

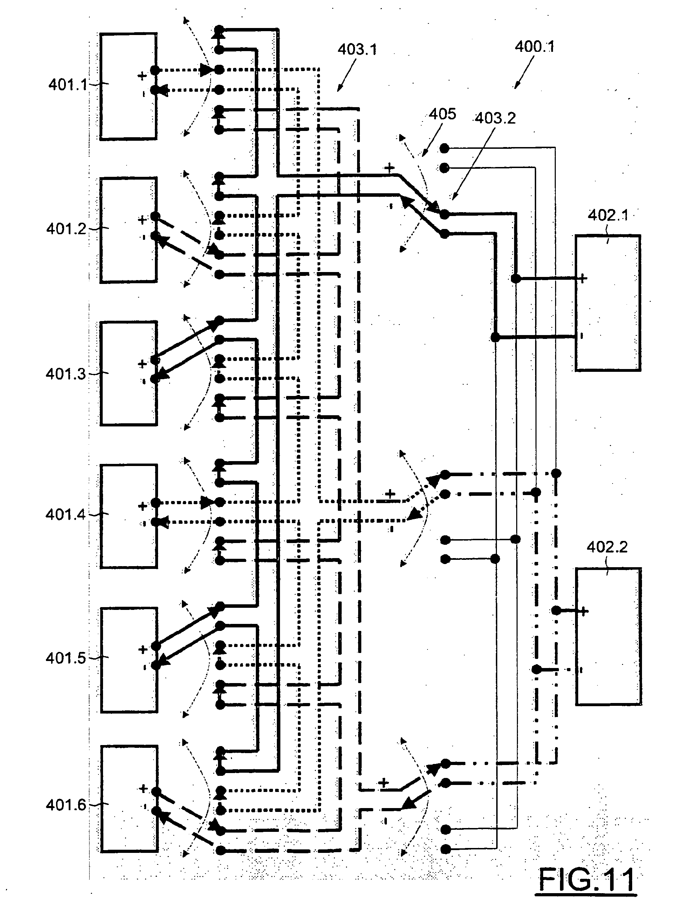

Selon une exécution particulière représentée sur la figure 11, l'installation énergétique 400.1 comprend six modules photovoltaïques 401.1 à 401.6 et deux onduleurs 402.1 et 402.2.

L'organe de commutation 403 comprend un groupe de commutateurs 403.1 et un groupe de commutateurs 403.2.

Le circuit électronique 404 comprend les moyens, adaptés, du circuit électronique 110 des figures 4 ou 6, de façon à établir sélectivement des groupes ou modes de connexions en série par paires des modules photovoltaïques 401.1 à 400.6, sur une paire de bornes 405.

Le circuit électronique 404 comprend en outre les moyens, adaptés, du circuit électronique de la figure 9, de façon à établir sélectivement une liaison entre la paire de bornes 405 et soit l'onduleur 402.1, soit l'onduleur 402.2.

Comme dans l'exemple décrit en référence à la figure 6, le choix d'une combinaison de connexions peut être soumis à des conditions supplémentaires dépendant des tensions d'entrée et/ou des puissances d'entrée susceptibles d'être supportées par les onduleurs 402.1 et 402.2.

C'est pourquoi, le circuit électronique de gestion et de commande 404 peut être adapté ou programmé pour sélectionner une combinaison de connexions ou un mode de connexion compatible avec les tensions et/ou les puissances susceptibles d'être supportées par les onduleurs 402.1 et 402.2

Selon une variante d'exécution, le circuit électronique 404 peut être adapté et programmé pour sélectionner et constituer deux groupes de modules photovoltaïques, dont l'un comprend certains des modules photovoltaïques et dont l'autre comprend les autres modules photovoltaïques, afin de relier ces groupes respectivement et sélectivement aux onduleurs 402.1 et 402.2 en accord avec leurs caractéristiques.

Par extension, à chaque cycle de sélection et de commande, en classant par exemple les valeurs des courants délivrés respectivement les N modules photovoltaïques d'une installation, le circuit électronique 404 peut être adapté et programmé pour sélectionner et constituer sélectivement x groupes constitués de y modules photovoltaïques en série et/ou en parallèle et relier sélectivement ces groupes en série et/ou en parallèle aux entrées d'un ou d'onduleurs, la somme des y étant égale à N ou inférieure dans le cas où certains modules photovoltaïques seraient déconnectés par le programme. Puis, le circuit électronique 404 commande l'organe de commutation 403 pour établir la combinaison de connexions sélectionnée et la maintenir jusqu'au cycle de sélection suivant.

Les modules photovoltaïques indiqués dans les exemples décrits peuvent comprendre des structures photovoltaïques composées de un ou de plusieurs panneaux à cellules photovoltaïques ou des structures photovoltaïques complexes comprenant, elles également, des modules photovoltaïques et des commutateurs séries/parallèles.

Les installations qui viennent d'être décrites présentent de nombreux avantages. En particulier, leurs modes de fonctionnement peuvent tenir compte des conditions d'ensoleillement et d'environnement variables des lieux déterminés où elles sont placées, en particulier lorsque certains modules photovoltaïques peuvent se retrouver au moins en partie à l'ombre au cours d'une journée. Leurs modes de fonctionnement peuvent tenir compte également des variations des états individuels des modules photovoltaïques, en particulier de leurs températures. Ainsi, dans la mesure où les performances individuelles de certains des modules photovoltaïques d'une installation seraient affectées, il n'en résulterait pas pour autant une affectation notable des performances de cette installation. En outre, leurs modes de fonctionnement peuvent tenir compte des conditions de fonctionnement d'organes récepteurs tels que des onduleurs pour obtenir un bon rendement.

Par ailleurs, les organes de commutation ou commutateurs prévus dans les installations décrites, à un étage ou à plusieurs étages successifs de commutation, peuvent comprendre, de façon connue en soi, des commutateurs électroniques de puissance programmés ou programmables et/ou des relais.

La présente invention ne se limite pas aux exemples ci-dessus décrits. En particulier, on peut concevoir des installations énergétiques comprenant toutes combinaisons des exemples décrits, sans limitation des modes de connexion.

## Revendications

1. Procédé de fonctionnement d'une installation énergétique comprenant au moins deux modules photovoltaïques et un onduleur, procédé **caractérisé en ce qu'**il comprend, respectivement à des instants prédéterminés, les étapes suivantes :
mesurer les valeurs du courant et/ou de la tension délivrés par chaque module photovoltaïque ;
calculer et/ou choisir une première grandeur électrique en fonction des valeurs mesurées dans le cas où lesdits modules photovoltaïques seraient connectés en un mode parallèle et une seconde grandeur électrique en fonction des valeurs mesurées dans le cas où lesdits modules photovoltaïques seraient connectés en un mode série ;
comparer lesdites première et seconde grandeurs électriques l'une par rapport à l'autre et/ou par rapport à une grandeur de référence ;
puis sélectionner et établir un mode de connexion des modules photovoltaïques à l'onduleur en fonction du résultat de la comparaison.

2. Procédé selon la revendication 1, dans lequel lesdites première et seconde grandeurs électriques sont des première et seconde puissances électriques et dans lequel le mode de connexion correspondant à la plus grande puissance calculée est choisi et établi.

3. Procédé selon la revendication 1, dans lequel lesdites première et seconde grandeurs électriques sont des valeurs de courants et dans lequel le mode de connexion correspondant au plus grand courant calculé est choisi et établi.

4. Procédé selon l'une des revendications 1 à 3, appliqué à une installation énergétique comprenant une multiplicité de modules photovoltaïques et au moins un onduleur, procédé comprenant, respectivement à des instants prédéterminés, les étapes suivantes :
mesurer les valeurs du courant et/ou de la tension délivrés par chaque module photovoltaïque;
calculer et/ou choisir des grandeurs électriques intermédiaires correspondant respectivement à une multiplicité de modes différents de connexion en mode série et/ou en mode parallèle desdits modules photovoltaïques;
comparer les grandeurs électriques intermédiaires les unes par rapport aux autres et/ou par rapport à une grandeur de référence;
puis sélectionner et établir un mode de connexion des modules photovoltaïques à l'onduleur en fonction du résultat de la comparaison.

5. Procédé selon la revendication 4, dans lequel lesdites grandeurs électriques intermédiaires sont des puissances électriques et dans lequel le mode de connexion correspondant à la plus grande puissance calculée est choisi et établi.

6. Procédé selon l'une des revendications 1 à 3, appliqué à une installation énergétique comprenant au moins deux onduleurs **caractérisés par** des grandeurs de fonctionnement et/ou des plages de grandeurs de fonctionnement différentes, procédé comprenant, respectivement à des instants prédéterminés, les étapes suivantes :
mesurer les valeurs du courant et/ou de la tension délivrés par au moins un module photovoltaïque;
calculer et/ou choisir une grandeur électrique intermédiaire en fonction des valeurs mesurées;
comparer cette grandeur électrique intermédiaire à au moins une grandeur de référence et/ou au moins une plage de grandeur de référence caractérisant électriquement chacun desdits onduleurs ;
puis relier ledit module soit à l'un desdits onduleurs soit à l'autre en fonction du résultat de ladite comparaison.

7. Procédé selon l'une des revendications 1 à 3, appliqué à une installation énergétique comprenant une multiplicité de modules photovoltaïques et une multiplicité d'onduleurs **caractérisés par** des grandeurs de fonctionnement et/ou des plages de grandeurs de fonctionnement différentes, procédé comprenant, respectivement à des instants prédéterminés, les étapes suivantes :
mesurer les valeurs du courant et/ou de la tension délivrés par chaque module photovoltaïque;
calculer et/ou choisir des grandeurs électriques intermédiaires en fonction d'une multiplicité de modes différents de connexion en mode série et/ou en mode parallèle des modules photovoltaïques aux onduleurs ;
comparer les grandeurs électriques intermédiaires les unes par rapport aux autres et/ou par rapport à des grandeurs de référence et/ou des plages de grandeurs de référence caractérisant électriquement les onduleurs ;
sélectionner et établir un mode de connexion des modules photovoltaïques auxdits onduleurs pour lequel la grandeur électrique intermédiaire correspond approximativement à une grandeur électrique de référence et/ou une plage de grandeurs électriques de référence caractérisant électriquement au moins l'un des onduleurs.

8. Procédé selon la revendication 7, dans lequel les grandeurs électriques intermédiaires sont des puissances électriques ou des courants.

9. Procédé selon l'une des revendications 1 à 3, appliqué à une installation énergétique comprenant une multiplicité de modules photovoltaïques et une multiplicité d'onduleurs **caractérisés par** des grandeurs de fonctionnement et/ou des plages de grandeurs de fonctionnement différentes, procédé comprenant, respectivement à des instants prédéterminés, les étapes suivantes :
mesurer les valeurs du courant et/ou de la tension délivrés par chaque module photovoltaïque;
calculer des grandeurs électriques de sortie des onduleurs en fonction d'une multiplicité de modes différents de connexion en mode série et/ou en mode parallèle des modules photovoltaïques aux onduleurs et en fonction de grandeurs électriques de fonctionnement et/ou de plages de grandeurs électriques de fonctionnement caractérisant électriquement les onduleurs,
comparer les grandeurs électriques de sortie calculées,
sélectionner et établir un mode de connexion des modules photovoltaïques auxdits onduleurs pour lequel la grandeur électrique de sortie calculée d'au moins l'un des onduleurs correspond approximativement à une grandeur de référence et/ou une plage de grandeurs de référence caractérisant électriquement cet onduleur.

10. Procédé selon la revendication 9, dans lequel les grandeurs électriques sont des puissances électriques et les grandeurs de fonctionnement et/ou de plages de grandeurs de fonctionnement sont des courbes de puissance.

11. Dispositif de commande d'une installation énergétique (1) comprenant une multiplicité de modules photovoltaïques (2,3) et au moins un onduleur (4), **caractérisé par le fait qu'**il comprend :
des moyens de commutation (5,6) pour sélectivement relier lesdits modules photovoltaïques audit onduleur en les connectant sélectivement en mode parallèle et/ou en mode série;
des moyens (8) pour mesurer la valeur du courant et/ou de la tension délivrés par lesdits modules photovoltaïques;
et des moyens (7) gestion et de commande des moyens de commutation en fonction des valeurs mesurées.

12. Dispositif selon la revendication 11, comprenant :
des premiers moyens de commutation (5) pour sélectivement placer lesdits modules photovoltaïques (2,3) en mode parallèle et/ou en mode série vers sélectivement des paires de bornes intermédiaires,
des seconds moyens de commutation (6) pour sélectivement relier lesdites paires de bornes intermédiaires aux onduleurs (4) en mode parallèle et/ou en mode série,
des moyens (8) pour mesurer la valeur du courant et/ou de la tension délivrés par chaque module photovoltaïque,
et des moyens de gestion et de commande (7) des premiers et seconds moyens de commutation en fonction des valeurs mesurées et/ou en fonction de grandeurs électriques ou de plages de grandeurs électriques caractérisant lesdits onduleurs.

## Claims

1. A method for operating an energy installation comprising at least two photovoltaic modules and an inverter, **characterized in that** said method comprising, respectively at pre-determined times, the following steps of:
measuring the values of the current and/or of the voltage supplied by each photovoltaic module;
calculating and/or choosing a first electrical magnitude according to the values measured in the event that said photovoltaic modules are connected in a parallel mode and a second electrical magnitude according to the values measured in the event that said photovoltaic modules are connected in a series mode;
comparing said first and second electrical magnitudes with each other and/or with a reference magnitude;
then selecting and establishing a connection mode of connecting the photovoltaic modules to the inverter according to the result of the comparison.

2. Method according to claim 1, wherein said first and second electrical magnitudes are first and second electrical powers and wherein the connection mode corresponding to the highest power calculated is chosen and established.

3. Method according to claim 1, wherein said first and second electrical magnitudes are current values and wherein the connection mode corresponding to the highest current calculated is chosen and established.

4. Method according to one of claims 1 to 2, applied to an energy installation comprising multiple photovoltaic modules and at least one inverter, said method comprising, respectively at pre-determined times, the following steps of:
measuring the values of the current and/or of the voltage supplied by each photovoltaic module;
calculating and/or choosing intermediate electrical magnitudes corresponding respectively to multiple various connection modes for connecting said photovoltaic modules in series mode and/or in parallel mode;
comparing the intermediate electrical magnitudes with each other and/or with a reference magnitude;
then selecting and establishing a connection mode of connecting the photovoltaic modules to the inverter according to the result of the comparison.

5. Method according to claim 4, wherein said intermediate electrical magnitudes are electrical powers and wherein the connection mode corresponding to the highest power calculated is chosen and established.

6. Method according to one of claims 1 to 3, applied to an energy installation comprising at least two inverters **characterized by** operating magnitudes and/or various ranges of operating magnitudes, said method comprising, respectively at pre-determined times, the following steps of:
measuring the values of the current and/or of the voltage supplied by at least one photovoltaic module;
calculating and/or choosing an intermediate electrical magnitude according to the values measured;
comparing this intermediate electrical magnitude with at least one reference magnitude and/or at least one range of reference magnitudes electrically characterizing each of said inverters;
then linking said module either to one of said inverters or to the other according to the result of said comparison.

7. Method according to one of claims 1 to 3, applied to an energy installation comprising multiple photovoltaic modules and multiple inverters **characterized by** operating magnitudes and/or various ranges of operating magnitudes, said method comprising, respectively at pre-determined times, the following steps of:
measuring the values of the current and/or of the voltage supplied by each photovoltaic module;
calculating and/or choosing intermediate electrical magnitudes according to multiple various connection modes for connecting the photovoltaic modules to the inverters in series mode and/or in parallel mode;
comparing the intermediate electrical magnitudes with each other and/or with reference magnitudes and/or ranges of reference magnitudes electrically characterizing the inverters;
selecting and establishing a connection mode of connecting the photovoltaic modules to said inverters for which the intermediate electrical magnitude corresponds approximately to a reference electrical magnitude and/or a range of reference electrical magnitudes electrically characterizing at least one of the inverters.

8. Method according to claim 7, wherein the intermediate electrical magnitudes are electrical powers or currents.

9. Method according to one of claims 1 to 3, applied to an energy installation comprising multiple photovoltaic modules and multiple inverters **characterized by** operating magnitudes and/or various ranges of operating magnitudes, said method comprising, respectively at pre-determined times, the following steps of:
measuring the values of the current and/or of the voltage supplied by each photovoltaic module;
calculating output electrical magnitudes of the inverters according to multiple various connection modes for connecting the photovoltaic modules to the inverters in series mode and/or in parallel mode and according to operating electrical magnitudes and/or ranges of operating electrical magnitudes electrically characterizing the inverters,
comparing the output electrical magnitudes calculated,
selecting and establishing a connection mode of connecting the photovoltaic modules to said inverters for which the calculated output electrical magnitude of at least one of the inverters corresponds approximately to a reference magnitude and/or a range of reference magnitudes electrically characterizing that inverter.

10. Method according to claim 9, wherein the electrical magnitudes are electrical powers and the operating magnitudes and/or ranges of operating magnitudes are power curves.

11. A device for controlling an energy installation comprising multiple photovoltaic modules and at least one inverter, **characterized in that** it comprises:
switching means to selectively link said photovoltaic modules to said inverter by connecting them selectively in parallel mode and/or in series mode;
means for measuring the value of the current and/or of the voltage supplied by said photovoltaic modules;
and means for managing and controlling the switching means according to the values measured.

12. Device according to claim 11, comprising:
first switching means to selectively put said photovoltaic modules into parallel mode and/or into series mode selectively to pairs of intermediate terminals,
second switching means to selectively link said pairs of intermediate terminals to the inverters in parallel mode and/or in series mode,
means for measuring the value of the current and/or of the voltage supplied by each photovoltaic module,
and means for managing and controlling the first and second switching means according to the values measured and/or according to electrical magnitudes or ranges of electrical magnitudes characterizing said inverters.

## Patentansprüche

1. Verfahren zum Betrieb einer Energieanlage, umfassend wenigstens zwei Sperrschichtmodule und einen Wechselrichter, Verfahren **dadurch gekennzeichnet, dass** es jeweils an vorbestimmten Zeitpunkten die folgenden Schritte umfasst:
Messung der Werte des Stroms und/oder der Spannung, die von jedem Sperrschichtmodul abgegeben werden;
Berechnung und/oder Wahl einer ersten elektrischen Größe in Abhängigkeit von den gemessenen Werten im Fall, dass die genannten Sperrschichtmodule in einem Parallelmodus angeschlossen wären und einer zweiten elektrischen Größe in Abhängigkeit von den gemessenen Werten im Fall, dass die genannten Sperrschichtmodule in einem Serienmodus angeschlossen wären;
Vergleich der genannten ersten und der genannten zweiten elektrischen Größe miteinander und/oder mit einer Bezugsgröße;
dann Wahl und Festlegung einer Anschlussart der Sperrschichtmodule an den Wechselrichter in Abhängigkeit von dem Ergebnis des Vergleichs.

2. Verfahren nach Anspruch 1, bei dem die genannte erste und die genannte zweite elektrische Größe erste und zweite elektrische Leistungen sind und bei dem die der größten berechneten Leistung entsprechende Anschlussart gewählt und festgelegt wird.

3. Verfahren nach Anspruch 1, bei dem die genannte erste und die genannte zweite elektrische Größe Stromwerte sind und bei dem die dem größten berechneten Strom entsprechende Anschlussart gewählt und festgelegt wird.

4. Verfahren nach einem der Ansprüche 1 bis 3, angewendet auf eine Energieanlage, die eine Vielzahl von Sperrschichtmodulen und wenigstens einen Wechselrichter umfasst, Verfahren, das jeweils an vorbestimmten Zeitpunkten die folgenden Schritte umfasst:
Messung der Werte des Stroms und/oder der Spannung, die von jedem Sperrschichtmodul abgegeben werden;
Berechnung und/oder Wahl elektrischer Zwischengrößen, die jeweils einer Vielzahl verschiedener Anschlussarten der genannten Sperrschichtmodule im Serien- und/oder Parallelmodus entsprechen;
Vergleich der elektrischen Zwischengrößen miteinander und/oder mit einer Bezugsgröße;
dann Wahl und Festlegung einer Art des Anschlusses der Sperrschichtmodule an den Wechselrichter in Abhängigkeit von dem Ergebnis des Vergleichs.

5. Verfahren nach Anspruch 4, bei dem die genannten elektrischen Zwischengrößen elektrische Leistungen sind und bei dem die der größten berechneten Leistung entsprechende Anschlussart gewählt und festgelegt wird.

6. Verfahren nach einem der Ansprüche 1 bis 3, angewendet auf eine Energieanlage, die wenigstens zwei durch verschiedene Betriebsgrößen und/oder Betriebsgrößenbereiche gekennzeichnete Wechselrichter umfasst, Verfahren, das jeweils an vorbestimmten Zeitpunkten die folgenden Schritte umfasst:
Messung der Werte des Stroms und/oder der Spannung, die von wenigstens einem Sperrschichtmodul abgegeben werden;
Berechnung und/oder Wahl einer elektrischen Zwischengröße in Abhängigkeit von den gemessenen Werten;
Vergleich dieser elektrischen Zwischengröße mit wenigstens einer Bezugsgröße und/oder wenigstens einem Bezugsgrößenbereich, die jeden der genannten Wechselrichter elektrisch kennzeichnen;
dann Verbindung des genannten Moduls in Abhängigkeit von dem Ergebnis des genannten Vergleichs entweder mit dem einen oder anderen der genannten Wechselrichter.

7. Verfahren nach einem der Ansprüche 1 bis 3, angewendet auf eine Energieanlage, die eine Vielzahl von Sperrschichtmodulen und eine Vielzahl von durch verschiedene Betriebsgrößen und/oder Betriebsgrößenbereiche gekennzeichneten Wechselrichtern umfasst, Verfahren, das jeweils an vorbestimmten Zeitpunkten die folgenden Schritte umfasst:
Messung der Werte des Stroms und/oder der Spannung, die von jedem Sperrschichtmodul abgegeben werden;
Berechnung und/oder Wahl elektrischer Zwischengrößen in Abhängigkeit von einer Vielzahl verschiedener Arten des Anschlusses der Sperrschichtmodule an die Wechselrichter im Serien- und/oder Parallelmodus;
Vergleich der elektrischen Zwischengrößen miteinander und/oder mit die Wechselrichter elektrisch kennzeichnenden Bezugsgrößen und/oder Bezugsgrößenbereichen;
Wahl und Festlegung einer Art des Anschlusses der Sperrschichtmodule an die genannten Wechselrichter, bei der die elektrische Zwischengröße annähernd einer elektrischen Bezugsgröße und/oder einem Bereich von elektrischen Bezugsgrößen entspricht, die wenigstens einen der Wechselrichter elektrisch kennzeichnen.

8. Verfahren nach Anspruch 7, bei dem die elektrischen Zwischengrößen elektrische Leistungen oder Ströme sind.

9. Verfahren nach einem der Ansprüche 1 bis 3, angewendet auf eine Energieanlage, die eine Vielzahl von Sperrschichtmodulen und eine Vielzahl von durch verschiedene Betriebsgrößen und/oder Betriebsgrößenbereiche gekennzeichneten Wechselrichtern umfasst, Verfahren, das jeweils an vorbestimmten Zeitpunkten die folgenden Schritte umfasst:
Messung der Werte des Stroms und/oder der Spannung, die von jedem Sperrschichtmodul abgegeben werden;
Berechnung elektrischer Ausgangsgrößen der Wechselrichter in Abhängigkeit von einer Vielzahl verschiedener Arten des Anschlusses der Sperrschichtmodule an die Wechselrichter im Serien- und/oder Parallelmodus und in Abhängigkeit von die Wechselrichter elektrisch kennzeichnenden elektrischen Betriebsgrößen und/oder Bereichen von elektrischen Betriebsgrößen,
Vergleich der berechneten elektrischen Ausgangsgrößen,
Wahl und Festlegung einer Art des Anschlusses der Sperrschichtmodule an die genannten Wechselrichter, bei der die berechnete elektrische Ausgangsgröße wenigstens eines der Wechselrichter annähernd einer Bezugsgröße und/oder einem Bezugsgrößenbereich entspricht, die diesen Wechselrichter elektrisch kennzeichnen.

10. Verfahren nach Anspruch 9, bei dem die elektrischen Größen elektrische Leistungen sind und die Betriebsgrößen und/oder Betriebsgrößenbereiche Leistungskurven sind.

11. Vorrichtung zur Steuerung einer Energieanlage (1), umfassend eine Vielzahl von Sperrschichtmodulen (2, 3) und wenigstens einen Wechselrichter (4), **dadurch gekennzeichnet, dass** sie folgendes umfasst:
Schaltmittel (5, 6) zur selektiven Verbindung der genannten Sperrschichtmodule mit dem genannten Wechselrichter, indem sie selektiv im Parallel- und/oder Serienmodus angeschlossen werden;
Mittel (8) zum Messen des Werts des Stroms und/oder der Spannung, die von den genannten Sperrschichtmodulen abgegeben werden;
und Leitungs- und Steuermittel (7) zum Leiten und Steuern der Schaltmittel in Abhängigkeit von den gemessenen Werten.

12. Vorrichtung nach Anspruch 11, umfassend:
erste Schaltmittel (5) zum selektiven Schalten der genannten Sperrschichtmodule (2, 3) im Parallel- und/oder Serienmodus selektiv in Bezug auf Zwischenklemmenpaare,
zweite Schaltmittel (6) zur selektiven Verbindung der genannten Zwischenklemmenpaare mit den Wechselrichtern im Parallel- und/oder Serienmodus,
Messmittel (8) zur Messung des Werts des Stroms und/oder der Spannung, die von jedem Sperrschichtmodul abgegeben werden,
und Leitungs- und Steuermittel (7) zum Leiten und Steuern der ersten und der zweiten Schaltmittel in Abhängigkeit von den gemessenen Werten und/oder in Abhängigkeit von die genannten Wechselrichter kennzeichnenden elektrischen Größen oder Bereichen von elektrischen Größen.
